# EUROPÄISCHE PATENTSCHRIFT

(11) **EP 3 308 463 B1**
(45) Veröffentlichungstag und Bekanntmachung des Hinweises auf die Patenterteilung: **12.08.2020**
(21) Anmeldenummer: 15731845.2
(22) Anmeldetag: 15.06.2015
(51) Int. Cl.: H03K 17/94, H03K 17/96, H03K 17/968

(54) **DRUCKTASTE UND VERFAHREN ZUM STEUERN EINES ELEKTRONISCHEN GERÄTS**
PUSH BUTTON AND METHOD FOR CONTROLLING AN ELECTRONIC APPLIANCE
BOUTON-POUSSOIR ET PROCÉDÉ DE COMMANDE D'UN APPAREIL ÉLECTRONIQUE

(43) Veröffentlichungstag der Anmeldung: 18.04.2018
(73) Patentinhaber: Diehl AKO Stiftung & Co. KG, 88239 Wangen (DE)
(72) Erfinder: MAIGLER, Andreas, 88339 Bad Waldsee (DE); FROMMELT, Thomas, 81243 München (DE); LYSZUS, Joachim, 88255 Baindt (DE); STOHR, Ralph, 88299 Leutkirch (DE); FUHGE, Bruno, 88147 Achberg (DE)
(74) Vertreter: Diehl Patentabteilung
(86) Internationale Anmeldenummer: PCT/EP2015/001199
(87) Internationale Veröffentlichungsnummer: WO 2016/202351

(56) Entgegenhaltungen:
- DE-A1- 10 244 452
- DE-A1-102004 058 478
- US-A1- 2014 103 199

## Beschreibung

Die vorliegende Erfindung betrifft eine Drucktaste, insbesondere eine Drucktaste für eine Bedienvorrichtung eines elektronischen Haushaltsgeräts, und ein Verfahren zum Steuern eines elektronischen Geräts, insbesondere eines elektronischen Haushaltsgeräts.

Für Bedienvorrichtungen sind verschiedene Arten von Bedienelementen mit unterschiedlichen Funktionsweisen bekannt. Bei den als Drucktasten ausgebildeten Bedienelementen kann man zum Beispiel zwischen berührungs- und/oder annäherungsempfindlichen Drucktasten (sog. "Touch Control") und durch Krafteinwirkung betätigbaren Drucktasten differenzieren, die jeweils mit verschiedenen Aufbauten und Funktionsweisen realisierbar sind.

Berührungs- und/oder annäherungsempfindliche Drucktasten weisen in der Regel eine starre Abdeckplatte auf, die einen Bedienabschnitt definiert und die in diesem Bedienabschnitt für Infrarot- oder sichtbare Strahlung zumindest teilweise durchlässig ausgestaltet ist. Ein optischer Sensor enthält wenigstens einen Sender zum Emittieren von elektromagnetischer Strahlung und wenigstens einen Empfänger zum Erfassen der vom Sender emittierten, durch den Bedienabschnitt gelaufenen und von einem Objekt wie zum Beispiel einem auf die Benutzerseite der Abdeckplatte aufgelegten Finger eines Benutzers reflektierten elektromagnetischen Strahlung. Eine solche Drucktaste ist beispielsweise aus DE 10 2006 004 979 B4 oder DE 10 2006 059 850 B4 der Anmelderin bekannt.

Bei den durch Krafteinwirkung betätigbaren Drucktasten sind neben solchen mit einem mechanischen Betätigungselement insbesondere auch kapazitive Drucktasten (vgl. z.B. DE 10 2011 121 897 A1), induktive Drucktasten (vgl. z.B. EP 2 529 484 B1) und piezoelektrische Drucktasten (vgl. z.B. EP 2 063 533 B1) bekannt. Diese speziellen Drucktasten erfordern im Allgemeinen eine hohe Fertigungs- und Montagegenauigkeit mit kleinen Toleranzbereichen.

Die US 2014/0103199 A1 offenbart eine Drucktaste, aufweisend eine einen Bedienabschnitt definierende Abdeckplatte mit einer einem Benutzer zugewandten Benutzerseite und einer dem Benutzer abgewandten Innenseite, einen Sender zum Emittieren von elektromagnetischer Strahlung und einen Empfänger zum Erfassen der vom Sender emittierten und von einem Objekt auf der Seite der Benutzerseite der Abdeckplatte reflektierten elektromagnetischen Strahlung, wobei der Sender und der Empfänger von einem reflektierenden Sensorrahmen umgeben und voneinander getrennt sind, sowie eine Steuereinrichtung zum Erfassen eines Abstands zwischen dem Empfänger und dem Objekt aus der von dem Empfänger erfassten elektromagnetischen Strahlung. Die Abdeckplatte ist im Bereich des Bedienabschnitts für die vom Sender emittierte elektromagnetische Strahlung zumindest teilweise durchlässig ausgestaltet ist. Außerdem ist die Abdeckplatte zumindest teilweise elastisch verformbar ausgestaltet, sodass durch einen Druck auf die Abdeckplatte der Sensorrahmen derart verformt wird, dass die von dem Empfänger erfasste Strahlungsmenge weiter erhöht wird.

Es ist die Aufgabe der vorliegenden Erfindung, eine verbesserte Drucktaste mit erweiterten Nutzungsmöglichkeiten zu schaffen. Es ist eine weitere Aufgabe der vorliegenden Erfindung, ein verbessertes Verfahren zum Steuern eines elektronischen Geräts mit erweiterten Steuerungsmöglichkeiten zu schaffen.

Diese Aufgaben werden gelöst durch die Lehre der unabhängigen Ansprüche. Besonders bevorzugte Ausgestaltungen und Weiterbildungen der Erfindung sind Gegenstand der abhängigen Ansprüche.

Die Drucktaste der Erfindung weist eine Abdeckplatte mit einer einem Benutzer zugewandten Benutzerseite und einer dem Benutzer abgewandten Innenseite, wobei die Abdeckplatte einen Bedienabschnitt definiert, sowie wenigstens einen Sender zum Emittieren von elektromagnetischer Strahlung und wenigstens einen Empfänger zum Erfassen der vom Sender emittierten und von einem Objekt auf der Seite der Benutzerseite der Abdeckplatte reflektierten elektromagnetischen Strahlung auf. Die Abdeckplatte ist in dem Bedienabschnitt für die vom Sender emittierte elektromagnetische Strahlung zumindest teilweise durchlässig ausgestaltet. Außerdem ist die Abdeckplatte in dem Bedienabschnitt zumindest teilweise elastisch verformbar und/oder bewegbar ausgestaltet. Da die Abdeckplatte in dem Bedienabschnitt einerseits für die vom Sender emittierte elektromagnetische Strahlung zumindest teilweise durchlässig ausgestaltet ist und andererseits zumindest teilweise elastisch verformbar und/oder bewegbar ausgestaltet ist, lassen sich bei der erfindungsgemäßen Drucktaste die Nutzungsmöglichkeiten einer berührungs- und/oder annäherungsempfindlichen Drucktaste mit den Nutzungsmöglichkeiten einer durch Krafteinwirkung betätigbaren Drucktaste kombinieren und sich so insgesamt erweitern. Auf diese Weise entstehen vorzugsweise auch größere Design- und Funktionsfreiheiten bei der Entwicklung und Herstellung von Bedienvorrichtungen von zum Beispiel elektronischen Haushaltsgeräten.

Die Abdeckplatte kann in diesem Zusammenhang grundsätzlich aus einem beliebigen Material (z.B. transparent oder lichtundurchlässig, elektrisch leitfähig oder elektrisch nicht leitend, etc.), mit beliebigen Dimensionierungen und mit einem beliebigen Design gefertigt sein. Bei der Abdeckplatte handelt es sich vorzugsweise um eine Bedienblende zum Beispiel eines elektronischen Haushaltsgeräts. Der Bedienabschnitt ist vorzugsweise einstückig mit der Abdeckplatte ausgebildet, als separate Komponente in die Abdeckplatte eingesetzt oder als separate Komponente fest mit der Abdeckplatte verbunden. Der Bedienabschnitt definiert für den Benutzer ein Bedienelement einer Bedienvorrichtung, das er zum Betätigen zum Beispiel berühren oder drücken kann. Der Bedienabschnitt kann vorzugsweise zusätzlich für den Benutzer kenntlich gemacht sein, bevorzugt durch eine spezielle Formgebung seiner Benutzerseite (haptische Kennzeichnung), eine Kennzeichnung mit Farben und/oder Symbolen und dergleichen.

Der Bedienabschnitt ist für die vom Sender emittierte elektromagnetische Strahlung zumindest teilweise durchlässig ausgestaltet. Bei der elektromagnetischen Strahlung handelt es sich vorzugsweise um Infrarot-Strahlung oder um Strahlung im sichtbaren Wellenlängenbereich. Die teilweise Durchlässigkeit für die Strahlung kann bevorzugt durch einen Transmissionsgrad von nennenswert größer Null und/oder durch eine zumindest lokal vorhandene Durchlässigkeit erreicht werden. Die Abdeckplatte ist im Bedienabschnitt vorzugsweise aus einem für die vom Sender emittierte Strahlung durchlässigen Material ausgebildet. Die Durchlässigkeit wird vorzugsweise durch einen Transmissionsgrad von wenigstens etwa 50%, bevorzugter wenigstens etwa 70% erreicht.

Der Bedienabschnitt ist durch eine Krafteinwirkung von der Benutzerseite der Abdeckplatte her zumindest teilweise elastisch verformbar und/oder bewegbar. Die elastische Verformbarkeit wird vorzugsweise durch eine spezielle Materialwahl und/oder eine spezielle Dimensionierung (insbes. in Dickenrichtung) des Bedienabschnitts erzielt. Die elastische Bewegbarkeit kann vorzugsweise durch eine gefederte Lagerung des Bedienabschnitts in einer Durchbrechung in der Abdeckplatte realisiert werden.

Die Drucktaste hat einen optischen Sensor, der wenigstens einen Sender und wenigstens einen Empfänger enthält. Der optische Sensor kann wahlweise genau einen Sender und genau einen Empfänger, zwei oder mehr Sender und genau einen Empfänger, genau einen Sender und zwei oder mehr Empfänger, oder zwei oder mehr Sender und zwei oder mehr Empfänger aufweisen. Bei den Sendern handelt es sich vorzugsweise um Leuchtdioden, Laserdioden, Glühlampen, Halogenlampen oder dergleichen. Bei den Empfängern handelt es sich vorzugsweise um CCD-Chips oder aktive Pixelsensoren oder um Anordnungen von Photodioden oder Phototransistoren.

Sender und Empfänger sind vorzugsweise auf einer Trägerplatte montiert, die auf der Seite der Innenseite der Abdeckplatte zu dieser beabstandet angeordnet ist. Diese Trägerplatte ist vorzugsweise als eine Leiterplatte ausgestaltet. Sender und Empfänger sind auf einer der Abdeckplatte zugewandten Seite der Trägerplatte und/oder auf einer der Abdeckplatte abgewandten Seite der Trägerplatte angeordnet. Die Trägerplatte ist vorzugsweise im Wesentlichen parallel zur Abdeckplatte angeordnet. Auf der Trägerplatte ist zudem vorzugsweise eine Steuereinrichtung zum Ansteuern des wenigstens einen Senders und Aufnehmen und Auswerten der Messsignale von dem wenigstens einen Empfänger angeordnet.

Erfindungsgemäß ist der wenigstens eine Empfänger derart angeordnet und/oder ausgestaltet, dass er eine ortsaufgelöste Erfassung der elektromagnetischen Strahlung ermöglicht. Außerdem ist eine Steuereinrichtung vorgesehen, die ausgestaltet ist, um aus der von dem wenigstens einen Empfänger ortsaufgelöst erfassten elektromagnetischen Strahlung einen Abstand und/oder eine Abstandsänderung zwischen dem wenigstens einen Empfänger und dem Objekt auf der Seite der Benutzerseite zu erfassen und aus dem erfassten Abstand oder der erfassten Abstandsänderung einen Betätigungszustand der Drucktaste zu bestimmen. Dieser Betätigungszustand ist ausgewählt aus einem Betätigungszustand, in dem der Bedienabschnitt durch eine Krafteinwirkung von der Benutzerseite her verformt oder verschoben ist, und wenigstens einem weiteren Betätigungszustand, in dem sich ein Objekt in der Nähe der Abdeckplatte, in der Nähe der Drucktaste oder auf dem Bedienabschnitt befindet.

In einer bevorzugten Ausgestaltung der Erfindung kann die Abdeckplatte in dem Bedienabschnitt für Strahlung im sichtbaren Wellenlängenbereich zumindest teilweise undurchlässig ausgestaltet sein. Auf diese Weise kann verhindert werden, dass der auf der Seite der Innenseite der Abdeckplatte angeordnete optische Sensor von einem Benutzer durch den Bedienabschnitt hindurch erkennbar ist. Im Ergebnis ist ein ansprechendes Design der Drucktaste bzw. der Bedienvorrichtung erzielbar. Die Undurchlässigkeit wird vorzugsweise durch einen Transmissionsgrad von weniger als etwa 30%, bevorzugter weniger als etwa 20% erreicht. Diese Ausgestaltung ist insbesondere bei Verwendung von Infrarot-Strahlung als elektromagnetische Strahlung von Sender und Empfänger von Vorteil.

Vorzugsweise kann die Innenseite der Abdeckplatte zumindest in dem Bedienabschnitt mit einer Beschichtung versehen sein, die für Strahlung im sichtbaren Wellenlängenbereich zumindest teilweise undurchlässig ist. Bei dieser Beschichtung handelt es sich vorzugsweise um eine elektrisch nicht leitende Beschichtung, die durch ein PVD-Verfahren (Physical Vapour Deposition), ein Siebdruck-Verfahren oder ein NCVM (None-Conductive Vacuum Metallization) aufgebracht wird.

In einer weiteren bevorzugten Ausgestaltung der Erfindung kann auf der Seite der Innenseite der Abdeckplatte ein Sensorrahmen vorgesehen sein, der für die von dem wenigstens einen Sender emittierte elektromagnetische Strahlung im Wesentlichen undurchlässig oder absorbierend ausgestaltet ist. Der Sensorrahmen bildet eine Schutzvorrichtung gegen störende Einflüsse aus der und in die Umgebung der Drucktaste, zum Beispiel von bzw. zu einer benachbarten Drucktaste. Der Sensorrahmen enthält vorzugsweise auch eine Trennwand zwischen dem wenigstens einen Sender und dem wenigstens einen Empfänger, um ein direktes Übersprechen zwischen Sender und Empfänger zu verhindern. Der Sensorrahmen kann bevorzugt auch als mechanischer Schutz für den optischen Sensor der Drucktaste dienen.

Gegenstand der Erfindung soll auch eine Bedienvorrichtung sein, die wenigstens eine oben beschriebene Drucktaste der Erfindung aufweist.

Die Bedienvorrichtung der Erfindung kann neben der erfindungsgemäßen Drucktaste optional weitere Drucktasten und Bedienelemente mit anderen Funktionsweisen enthalten.

In einer bevorzugten Ausgestaltung der Erfindung kann die Bedienvorrichtung mehrere Drucktasten gemäß der Erfindung aufweisen. Vorzugsweise können die Sender und/oder Empfänger dieser mehreren Drucktasten von einer gemeinsamen Steuereinrichtung separat getaktet werden.

Gegenstand der Erfindung soll schließlich auch ein elektronisches Haushaltsgerät mit wenigstens einer oben beschriebenen Bedienvorrichtung der Erfindung sein.

Bei dem elektronischen Haushaltsgerät handelt es sich vorzugsweise um ein Wäschebehandlungsgerät (Waschmaschine, Wäschetrockner, etc.), eine Spülmaschine, ein Kühl- und/oder Gefriergerät, ein Kochfeld, einen Herd, einen Mikrowellenofen, eine Dunstabzugshaube oder dergleichen.

Das erfindungsgemäße Verfahren zum Steuern eines elektronischen Geräts verwendet wenigstens eine oben beschriebene Drucktaste gemäß der Erfindung. Insbesondere weist die wenigstens eine Drucktaste auf: eine Abdeckplatte mit einer einem Benutzer zugewandten Benutzerseite und einer dem Benutzer abgewandten Innenseite, wobei die Abdeckplatte einen Bedienabschnitt definiert, sowie wenigstens einen Sender zum Emittieren von elektromagnetischer Strahlung und wenigstens einen Empfänger zum Erfassen der vom Sender emittierten und von einem Objekt auf der Seite der Benutzerseite der Abdeckplatte reflektierten elektromagnetischen Strahlung, wobei die Abdeckplatte in dem Bedienabschnitt für die vom Sender emittierte elektromagnetische Strahlung zumindest teilweise durchlässig ausgestaltet ist und wobei die Abdeckplatte in dem Bedienabschnitt zumindest teilweise elastisch verformbar und/oder bewegbar ausgestaltet ist. Gemäß der Erfindung wird die elektromagnetische Strahlung durch den wenigstens einen Empfänger ortsaufgelöst erfasst und können aus der von dem wenigstens einen Empfänger ortsaufgelöst erfassten elektromagnetischen Strahlung ein Abstand und/oder eine Abstandsänderung zwischen dem wenigstens einen Empfänger und dem Objekt erfasst werden und kann aus dem erfassten Abstand oder der erfassten Abstandsänderung ein Betätigungszustand der Drucktaste bestimmt werden. Dieser bestimmbare Betätigungszustand der Drucktaste ist ausgewählt aus einem Betätigungszustand, in dem der Bedienabschnitt durch eine Krafteinwirkung von der Benutzerseite her verformt oder verschoben ist, und wenigstens einem weiteren Betätigungszustand, in dem sich ein Objekt in der Nähe der Abdeckplatte, in der Nähe der Drucktaste oder auf dem Bedienabschnitt befindet.

In einer bevorzugten Ausgestaltung der Erfindung werden die Betätigungszustände mehrerer Drucktasten bestimmt, wobei die Sender und/oder Empfänger der mehreren Drucktasten separat getaktet werden.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine Schnittansicht einer Drucktaste gemäß einem Ausführungsbeispiel der Erfindung;
- Fig. 2: eine Darstellung des Funktionsprinzips einer Bedienvorrichtung mit mehreren Drucktasten gemäß der Erfindung in einem ersten Betätigungszustand;
- Fig. 3: eine Darstellung des Funktionsprinzips einer Drucktaste gemäß der Erfindung in einem zweiten Betätigungszustand;
- Fig. 4: eine Darstellung des Funktionsprinzips einer Drucktaste gemäß der Erfindung in einem dritten Betätigungszustand;
- Fig. 5: eine Darstellung des Funktionsprinzips einer Drucktaste gemäß der Erfindung in einem vierten Betätigungszustand;
- Fig. 6: eine Schnittansicht einer Bedienvorrichtung mit mehreren Drucktasten gemäß einem weiteren Ausführungsbeispiel der Erfindung;
- Fig. 6A: eine Darstellung der Anordnung von Sendern und Empfängern der Drucktaste von Fig. 6;
- Fig. 6B: eine Darstellung der Anordnung von Sendern und Empfängern einer Variante der Drucktaste von Fig. 6;
- Fig. 7A: eine Draufsicht eines Sensorrahmens einer Drucktaste gemäß einem Ausführungsbeispiel der Erfindung;
- Fig. 7B: eine Seitenansicht des Sensorrahmens von Fig. 7A gemäß Ansicht von rechts in Fig. 7A; und
- Fig. 7C: eine Seitenansicht des Sensorrahmens von Fig. 7A gemäß Ansicht von unten in Fig. 7A.

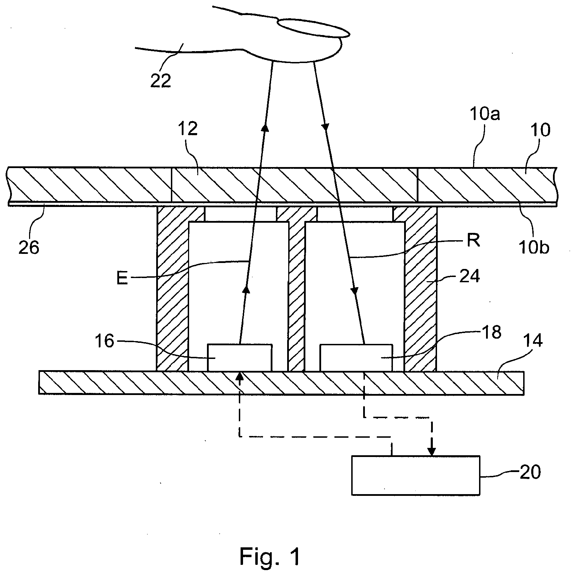

Bezugnehmend auf Fig. 1 wird zunächst der Aufbau einer Drucktaste gemäß einem Ausführungsbeispiel der Erfindung näher erläutert.

Die Drucktaste weist eine Abdeckplatte 10 in Form einer Bedienblende auf. Die Abdeckplatte 10 ist beispielsweise aus Glas, Glaskeramik, Metall oder einem Kunststoffmaterial gefertigt. Die Abdeckplatte 10 hat eine dem Benutzer zugewandte Benutzerseite 10a (oben in Fig. 1), welche der Außenseite der Bedienblende entspricht, und eine dem Benutzer abgewandte Innenseite 10b (unten in Fig. 1).

Die Abdeckplatte 10 weist einen Bedienabschnitt 12 auf, der für den Benutzer ein Bedienelement definiert, das er betätigen kann. Der Bedienabschnitt 12 ist in die Abdeckplatte 10 integriert bzw. einteilig mit dieser ausgebildet oder als separate Komponente in diese eingesetzt und wahlweise mit dieser verbunden.

Die Bedienvorrichtung weist ferner eine Trägerplatte 14 in Form einer Leiterplatte auf. Diese Trägerplatte 14 ist im Wesentlichen parallel zur Abdeckplatte 10 ausgerichtet und auf der Seite der Innenseite 10b der Abdeckplatte 10 beabstandet zu dieser angeordnet. Auf dieser Trägerplatte 14 ist - in diesem Ausführungsbeispiel auf ihrer der Abdeckplatte 10 zugewandten Seite - an einer dem Bedienabschnitt 12 entsprechenden Position ein optischer Sensor angeordnet.

Dieser optische Sensor weist wenigstens einen Sender 16 zum Beispiel in Form einer Leuchtdiode und wenigstens einen Empfänger 18 zum Beispiel in Form eines CCD-Chips auf. Der Sender 16 emittiert elektromagnetische Strahlung, vorzugsweise im sichtbaren oder Infrarot-Wellenlängenbereich, und der Empfänger 18 kann elektromagnetische Strahlung desselben Wellenlängenbereichs erfassen.

Der Bedienabschnitt 12 der Drucktaste ist zumindest teilweise für die vom Sender 16 emittierte Strahlung durchlässig ausgestaltet. Wie in Fig. 1 veranschaulicht, trifft der vom Sender 16 emittierte Strahl E nach Durchlaufen des Bedienabschnitts 12 der Abdeckplatte 10 auf der Seite der Benutzerseite 10a im Fall einer Tastenbetätigung durch einen Benutzer auf ein Objekt 22, zum Beispiel auf einen Finger des Benutzers, und wird an diesem reflektiert. Der reflektierte Strahl R kann dann nach Durchlaufen des Bedienabschnitts 12 vom Empfänger 18 erfasst werden. Dabei ermöglicht der Empfänger 18 eine ortsaufgelöste Erfassung des reflektierten Strahls R.

Sender 16 und Empfänger 18 des optischen Sensors sind mit einer Steuereinrichtung 20 verbunden. Diese Steuereinrichtung 20 ist zum Beispiel ebenfalls auf der Trägerplatte 14 montiert. Die Steuereinrichtung 20 steuert den wenigstens einen Sender 16 an, nimmt die Messsignale des wenigstens einen Empfängers 18 auf und wertet diese aus.

Bei der erfindungsgemäß ausgestalteten Drucktaste ist der Bedienabschnitt 12 außerdem zumindest teilweise elastisch verformbar und/oder bewegbar ausgestaltet. Die Verformung oder Bewegung des Bedienabschnitts 12 kann vom Benutzer durch eine Drucckraft auf den Bedienabschnitt 12 von der Benutzerseite 10a der Abdeckplatte 10 her ausgelöst werden. Nach Beendigung der Krafteinwirkung kehrt der Bedienabschnitt 12 wieder in seinen Ausgangszustand von Fig. 1 zurück.

Wie in Fig. 1 dargestellt, weist die Drucktaste bevorzugt ferner einen Sensorrahmen 24 auf, in dem der wenigstens eine Sender 16 und der wenigstens eine Empfänger 18 aufgenommen sind. Der Sensorrahmen 24 ist für die vom Sender 16 emittierte Strahlung im Wesentlichen undurchlässig oder absorbierend, beispielsweise aus einem entsprechenden Material gefertigt und/oder entsprechend beschichtet. Der Sensorrahmen 24 dient so der optischen Abschirmung des optischen Sensors sowohl zum Beispiel gegen Fremdstrahlung von außen als auch gegen Ausbreitung der vom Sender 16 emittierten Strahlung nach außen. Wie in Fig. 1 angedeutet, kann der Sensorrahmen 24 auch eine Trennwand zwischen Sender 16 und Empfänger 18 enthalten, sodass ein direktes Übersprechen des emittierten Strahls E zum Empfänger 18 verhindert werden kann. Zusätzlich kann der Sensorrahmen 24 auch als mechanischer Schutz für den optischen Sensor dienen.

Zur Verbesserung des Designs der Drucktaste und damit der gesamten Bedienvorrichtung kann die Innenseite 10b der Abdeckung 10, insbesondere im Bereich des Bedienabschnitts 12, mit einer Beschichtung 26 versehen sein, die für Strahlung im sichtbaren Wellenlängenbereich zumindest teilweise undurchlässig ist. Auf diese Weise kann der optische Sensor hinter der Abdeckplatte 10 auch im Fall eines an sich transparenten Bedienabschnitts 12 für den Benutzer unkenntlich gemacht werden. Im Fall einer insgesamt transparenten Abdeckplatte 10 ist bevorzugt deren gesamte Innenseite 10b mit einer solchen Beschichtung 26 versehen.

Bei der Beschichtung 26 handelt es sich vorzugsweise um eine elektrisch nicht leitende Beschichtung, die beispielsweise durch ein PVD-Verfahren (Physical Vapour Deposition), ein (Sieb-)Druck-Verfahren oder ein NCVM (None-Conductive Vacuum Metallization) aufgebracht werden kann. Derartige Beschichtungsverfahren sind dem Fachmann grundsätzlich bekannt (vgl. z.B. DE 10 2008 053 351 B3), weshalb sie an dieser Stelle nicht näher erläutert werden müssen.

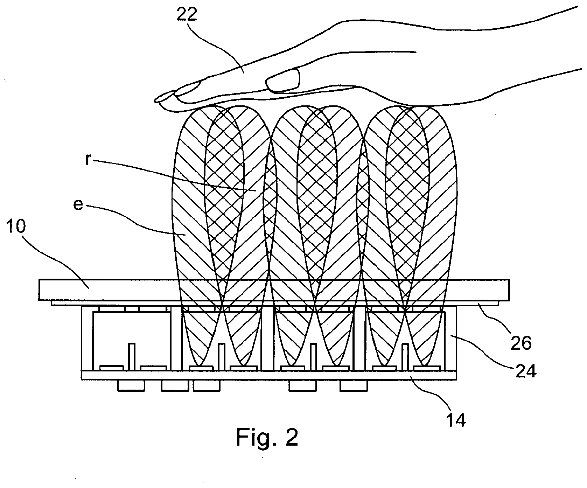

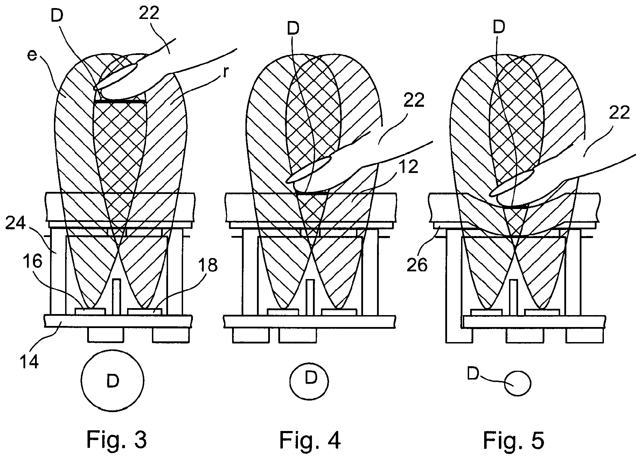

Wie nachfolgend anhand der Fig. 2 bis 5 näher erläutert, können von dem optischen Sensor verschiedene Positionen eines Objekts 22 erfasst werden. Hierzu zählen insbesondere ein Objekt 22 in der Nähe der Bedienvorrichtung (vgl. Fig. 2), ein Objekt 22 in der Nähe der Drucktaste (vgl. Fig. 3), ein Objekt 22 auf dem Bedienabschnitt 12 der Drucktaste (vgl. Fig. 4) und ein auf den Bedienabschnitt 12 drückendes Objekt (vgl. Fig. 5). Insgesamt können von der Drucktaste der Erfindung somit Funktionen einer berührungs- und/oder annäherungsempfindlichen Drucktaste (vgl. Fig. 2 bis 4) sowie Funktionen einer durch Krafteinwirkung betätigbaren Drucktaste (vgl. Fig. 5) realisiert werden. Die Nutzungsmöglichkeiten der Drucktaste können durch diese Erweiterung der erfassbaren Betätigungszustände entsprechend erweitert werden.

Fig. 2 stellt die generelle Annäherung (auch "Präsenz" genannt) eines Objekts 22 an die Bedienvorrichtung zum Beispiel eines Haushaltsgeräts dar. Hierbei wird das Objekt 22 vom optischen Sensor 16, 18 der Drucktaste schon erkannt, bevor es die Benutzerseite 10a der Abdeckplatte 10 erreicht. Zu diesem Zweck sind über die Steuereinrichtung 20 bevorzugt mehrere Drucktasten der Bedienvorrichtung zu einem großen Bedienelement funktional zusammengeschlossen und/oder getaktet ansteuerbar. Bei dieser Präsenz handelt es sich um eine rein statische Erfassung, nicht um eine Geste oder dergleichen. Wird von der Steuereinrichtung 20 eine Präsenz eines Objekts 22 in der Nähe der Bedienvorrichtung erkannt, kann als Funktion zum Beispiel ein schwaches Leuchten aller vorhandenen bzw. aller betätigbaren Drucktasten der Bedienvorrichtung erfolgen.

Fig. 3 stellt die tastenbezogene Annäherung (auch "Proximity" genannt) eines Objekts 22 an die Drucktaste der Bedienvorrichtung dar. Hierbei wird das Objekt 22, zum Beispiel ein Finger des Benutzers, in der Nähe einer bestimmten Drucktaste erkannt, bevor das Objekt 22 den Bedienabschnitt 22 erreicht. Wird von der Steuereinrichtung 20 eine solche Proximity eines Objekts 22 in Bezug zu einer Drucktaste der Bedienvorrichtung erkannt, kann als Funktion zum Beispiel ein gegenüber dem Betätigungszustand von Fig. 3 stärkeres Leuchten dieser speziellen Drucktaste erfolgen.

Fig. 4 zeigt den Betätigungszustand der Berührung einer Drucktaste, genauer des Bedienabschnitts 12 einer Drucktaste (auch "Soft Touch" genannt). Das Objekt 22 muss dabei den Bedienabschnitt 12 nur leicht berühren, um diese Drucktaste zu betätigen, damit eine für diese Drucktaste hinterlegte Funktion ausgeführt wird.

Fig. 5 zeigt den Betätigungszustand des Drückens einer Drucktaste, genauer des Bedienabschnitts 12 einer Drucktaste (auch "Force Touch" genannt). Dabei wird auf den Bedienabschnitt 12 der Drucktaste durch das Objekt 22 eine leichte Druckkraft ausgeübt, sodass sich der Bedienabschnitt 12 elastisch verformt. Als Folge dieser Druckbetätigung der Drucktaste wird eine weitere für diese Drucktaste hinterlegte Funktion ausgeführt.

In Fig. 3 bis 5 ist jeweils auch ein im Wesentlichen kreisförmiger Detektionsbereich D dargestellt, der sich als Schnittfläche der Emissionskeule e des Senders 16 und der Detektionskeule r des Empfängers 18 in der Ebene des Objekts 22 ergibt. Die je nach Betätigungszustand der Drucktaste unterschiedlich großen Detektionsbereiche D resultieren in entsprechend unterschiedlichen reflektierten Strahlen R, die von dem ortsauflösend detektierenden Empfänger 18 differenziert und dann von der Steuereinrichtung 20 entsprechend ausgewertet werden können.

Die Drucktaste der Erfindung ist nicht auf die anhand der Fig. 1 bis 5 beschriebene Ausführungsform beschränkt. Im Rahmen der Erfindung sind zahleiche Varianten denkbar, die der Fachmann anhand der vorliegenden Erfindung erkennen wird.

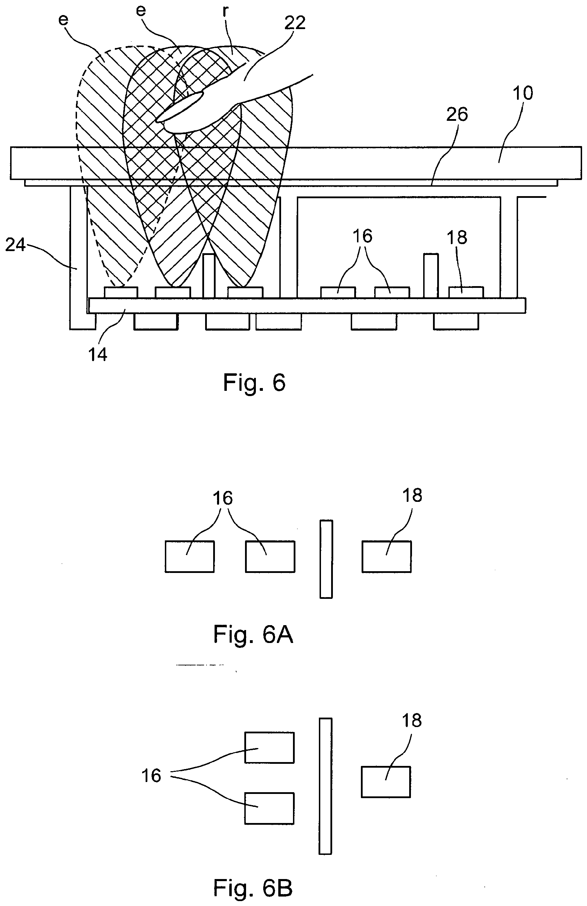

So zeigt Fig. 6 mögliche Ausführungsvarianten des optischen Sensors, bei denen jeweils zwei Sender 16 einem Empfänger 18 zugeordnet sind. Wie beispielhaft in Fig. 6A und 6B gezeigt, sind dabei verschiedene Anordnungen von Sendern 16 und Empfänger 18 denkbar. Jedem der mehreren Sender 16 kann dabei eine eigene Funktion zugewiesen werden. Die mehreren Sender können wahlweise getaktet werden.

Alternativ zu Fig. 6, 6A und 6B kann ein Empfänger 18 auch mit mehr als zwei Sendern 16 kombiniert werden. Als weitere Alternative können auch einem Sender 16 mehrere Empfänger 18 zugeordnet werden. In einer Ausführungsvariante kann eine Drucktaste auch mehrere Sender 16 und mehrere Empfänger 18 aufweisen.

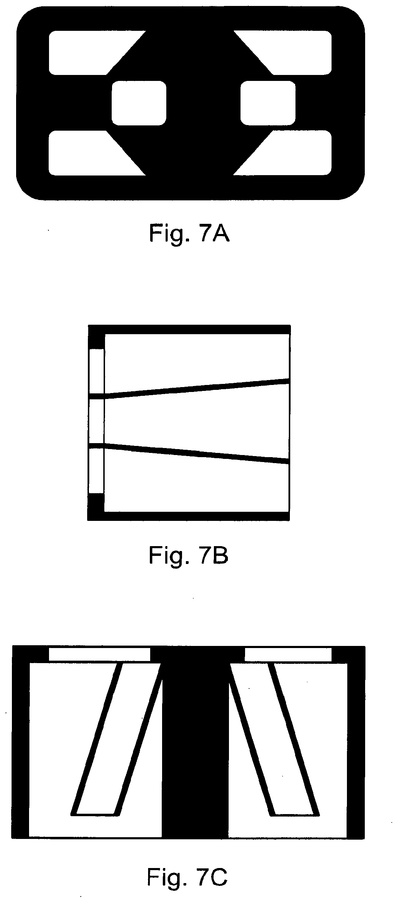

Weiter ist es möglich, die Differenzierung der verschiedenen Betätigungszustände bzw. deren differenzierte Erfassung durch den/die Empfänger 18 durch eine spezielle mechanische Ausgestaltung des Sensorrahmens 24 zu unterstützen. Wie in Fig. 7A-C beispielhaft veranschaulicht, kann der Sensorrahmen 24 wahlweise verschiedene Durchbrechungen, Winkel, Strahlungsleitelemente, etc. aufweisen, welche die Strahlungsführung innerhalb des Sensorrahmens 24 gezielt beeinflussen können.

### BEZUGSZIFFERNLISTE

- 10: Abdeckplatte, z.B. Bedienblende
- 10a: Benutzerseite
- 10b: Innenseite
- 12: Bedienabschnitt
- 14: Trägerplatte, z.B. Leiterplatte
- 16: Sender
- 18: Empfänger
- 20: Steuereinrichtung
- 22: Objekt, z.B. Finger
- 24: Sensorrahmen
- 26: Beschichtung
- D: Detektionsbereich
- e: Emissionskeule
- E: emittierter Strahl
- r: Detektionskeule
- R: reflektierter Strahl

## Patentansprüche

1. Drucktaste, insbesondere für ein elektronisches Haushaltsgerät, aufweisend:
eine Abdeckplatte (10) mit einer einem Benutzer zugewandten Benutzerseite (10a) und einer dem Benutzer abgewandten Innenseite (10b), wobei die Abdeckplatte (10) einen Bedienabschnitt (12) definiert; und
wenigstens einen Sender (16) zum Emittieren von elektromagnetischer Strahlung und wenigstens einen Empfänger (18) zum Erfassen der vom Sender (16) emittierten und von einem Objekt (22) auf der Seite der Benutzerseite (10a) der Abdeckplatte (10) reflektierten elektromagnetischen Strahlung,
wobei die Abdeckplatte (10) in dem Bedienabschnitt (12) für die vom Sender (16) emittierte elektromagnetische Strahlung zumindest teilweise durchlässig ausgestaltet ist, und
wobei die Abdeckplatte (10) in dem Bedienabschnitt (12) zumindest teilweise elastisch verformbar und/oder bewegbar ausgestaltet ist,
wobei der wenigstens eine Empfänger (18) derart angeordnet und/oder ausgestaltet ist, dass er eine ortsaufgelöste Erfassung der elektromagnetischen Strahlung ermöglicht; und
die Drucktaste ferner eine Steuereinrichtung (20) aufweist, die ausgestaltet ist, um aus der von dem wenigstens einen Empfänger (18) ortsaufgelöst erfassten elektromagnetischen Strahlung einen Abstand und/oder eine Abstandsänderung zwischen dem wenigstens einen Empfänger (18) und dem Objekt (22) zu erfassen und aus dem erfassten Abstand oder der erfassten Abstandsänderung einen Betätigungszustand der Drucktaste zu bestimmen, **dadurch gekennzeichnet, dass** der Betätigungszustand ausgewählt ist aus einem Betätigungszustand, in dem der Bedienabschnitt (12) durch eine Krafteinwirkung von der Benutzerseite (10a) her verformt oder verschoben ist, und wenigstens einem weiteren Betätigungszustand, in dem sich ein Objekt (22) in der Nähe der Abdeckplatte (10), in der Nähe der Drucktaste oder auf dem Bedienabschnitt (12) befindet.

2. Drucktaste nach Anspruch 1, bei welcher
die Innenseite (10b) der Abdeckplatte (10) zumindest in dem Bedienabschnitt (12) mit einer Beschichtung (26) versehen ist, die für Strahlung im sichtbaren Wellenlängenbereich zumindest teilweise undurchlässig ist.

3. Drucktaste nach einem der vorhergehenden Ansprüche, bei welcher
auf der Seite der Innenseite (10b) der Abdeckplatte (10) ein Sensorrahmen (24) vorgesehen ist, der für die von dem wenigstens einen Sender (16) emittierte elektromagnetische Strahlung im Wesentlichen undurchlässig oder absorbierend ausgestaltet ist.

4. Bedienvorrichtung, insbesondere für ein elektronisches Haushaltsgerät, mit wenigstens einer Drucktaste nach einem der vorhergehenden Ansprüche.

5. Bedienvorrichtung nach Anspruch 4, welche mehrere Drucktasten nach einem der Ansprüche 1 bis 3 aufweist, deren Sender und/oder Empfänger von einer gemeinsamen Steuereinrichtung (20) separat getaktet werden.

6. Elektronisches Haushaltsgerät mit wenigstens einer Bedienvorrichtung nach Anspruch 4 oder 5.

7. Verfahren zum Steuern eines elektronischen Geräts, insbesondere eines elektronischen Haushaltsgeräts, mittels wenigstens einer Drucktaste, bei welchem die wenigstens eine Drucktaste aufweist: eine Abdeckplatte (10) mit einer einem Benutzer zugewandten Benutzerseite (10a) und einer dem Benutzer abgewandten Innenseite (10b), wobei die Abdeckplatte (10) einen Bedienabschnitt (12) definiert, sowie wenigstens einen Sender (16) zum Emittieren von elektromagnetischer Strahlung und wenigstens einen Empfänger (18) zum Erfassen der vom Sender (16) emittierten und von einem Objekt (22) auf der Seite der Benutzerseite (10a) der Abdeckplatte (10) reflektierten elektromagnetischen Strahlung, wobei die Abdeckplatte (10) in dem Bedienabschnitt (12) für die vom Sender (16) emittierte elektromagnetische Strahlung zumindest teilweise durchlässig ausgestaltet ist und wobei die Abdeckplatte (10) in dem Bedienabschnitt (12) zumindest teilweise elastisch verformbar und/oder bewegbar ausgestaltet ist,
wobei die elektromagnetische Strahlung durch den wenigstens einen Empfänger (18) ortsaufgelöst erfasst wird; und
aus der von dem wenigstens einen Empfänger (18) ortsaufgelöst erfassten elektromagnetischen Strahlung ein Abstand und/oder eine Abstandsänderung zwischen dem wenigstens einen Empfänger (18) und dem Objekt (22) erfasst werden und aus dem erfassten Abstand oder der erfassten Abstandsänderung ein Betätigungszustand der Drucktaste bestimmt wird, **dadurch gekennzeichnet, dass** der Betätigungszustand der Drucktaste ausgewählt ist aus einem Betätigungszustand, in dem der Bedienabschnitt (12) durch eine Krafteinwirkung von der Benutzerseite (10a) her verformt oder verschoben ist, und wenigstens einem weiteren Betätigungszustand, in dem sich ein Objekt (22) in der Nähe der Abdeckplatte (10), in der Nähe der Drucktaste oder auf dem Bedienabschnitt (12) befindet.

8. Verfahren nach Anspruch 7, bei welchem
die Betätigungszustände mehrerer Drucktasten bestimmt werden, wobei die Sender und/oder Empfänger der mehreren Drucktasten separat getaktet werden.

## Claims

1. Pushbutton, in particular for an electronic household appliance, having:
a cover plate (10) having a user side (10a) facing a user and an inner side (10b) averted from the user, wherein the cover plate (10) defines an operator control section (12); and
at least one transmitter (16) for emitting electromagnetic radiation and at least one receiver (18) for detecting the electromagnetic radiation emitted by the transmitter (16) and reflected from an object (22) on the user side (10a) side of the cover plate (10),
wherein the cover plate (10) is designed so that the operator control section (12) is at least partially impermeable to the electromagnetic radiation emitted by the transmitter (16),
wherein the cover plate (10) is designed so that at least part of the operator control section (12) is elastically deformable and/or movable,
wherein the at least one receiver (18) is arranged and/or designed such that it allows spatially resolved detection of the electromagnetic radiation; and
the pushbutton further has a control device (20) that is designed to use the electromagnetic radiation detected in a spatially resolved manner by the at least one receiver (18) to detect a distance and/or a change of distance between the at least one receiver (18) and the object (22) and to use the detected distance or the detected change of distance to determine an operated state of the pushbutton, **characterized in that** the operated state is selected from an operated state in which the operator control section (12) is deformed or displaced by a force acting from the user side (10a) and at least one further operated state, in which an object (22) is situated close to the cover plate (10), close to the pushbutton or on the operator control section (12).

2. Pushbutton according to Claim 1, in which at least the operator control section (12) of the inner side (10b) of the cover plate (10) is provided with a coating (26) that is at least partially impermeable to radiation in the visible wavelength range.

3. Pushbutton according to either of the preceding claims, in which
there is provision on the inner side (10b) side of the cover plate (10) for a sensor frame (24) that is designed to be substantially impermeable to or absorbent for the electromagnetic radiation emitted by the at least one transmitter (16).

4. Operator control apparatus, in particular for an electronic household appliance, having at least one pushbutton according to one of the preceding claims.

5. Operator control apparatus according to Claim 4, which has multiple pushbuttons according to one of Claims 1 to 3, the transmitters and/or receivers of which are clocked separately by a common control device (20) .

6. Electronic household appliance having at least one operator control apparatus according to Claim 4 or 5.

7. Method for controlling an electronic appliance, in particular an electronic household appliance, by means of at least one pushbutton, in which the at least one pushbutton has: a cover plate (10) having a user side (10a) facing a user and an inner side (10b) averted from the user, wherein the cover plate (10) defines an operator control section (12), and also at least one transmitter (16) for emitting electromagnetic radiation and at least one receiver (18) for detecting the electromagnetic radiation emitted by the transmitter (16) and reflected from an object (22) on the user side (10a) side of the cover plate (10), wherein the cover plate (10) is designed so that the operator control section (12) is at least partially impermeable to the electromagnetic radiation emitted by the transmitter (16) and wherein the cover plate (10) is designed so that at least part of the operator control section (12) is elastically deformable and/or movable, wherein the electromagnetic radiation is detected in a spatially resolved manner by the at least one receiver (18); and the electromagnetic radiation detected in a spatially resolved manner by the at least one receiver (18) is used to detect a distance and/or a change of distance between the at least one receiver (18) and the object (22), and the detected distance or the detected change of distance is used to determine an operated state of the pushbutton, **characterized in that** the operated state of the pushbutton is selected from an operated state in which the operator control section (12) is deformed or displaced by a force acting from the user side (10a) and at least one further operated state, in which an object (22) is situated close to the cover plate (10), close to the pushbutton or on the operator control section (12).

8. Method according to Claim 7, in which the operated states of multiple pushbuttons are determined, wherein the transmitters and/or receivers of the multiple pushbuttons are clocked separately.

## Revendications

1. Bouton-poussoir, notamment pour un appareil ménager électronique, comprenant :
une plaque de recouvrement (10) pourvue d'un côté utilisateur (10a) qui fait face à un utilisateur et d'un côté intérieur (10b) à l'opposé de l'utilisateur, la plaque de recouvrement (10) définissant une portion d'opération (12) ; et
au moins un émetteur (16) destiné à émettre un rayonnement électromagnétique et au moins un récepteur (18) destiné à recevoir le rayonnement électromagnétique émis par l'émetteur (16) et réfléchi par un objet (22) sur le côté du côté utilisateur (10a) de la plaque de recouvrement (10),
la plaque de recouvrement (10) étant configurée au moins partiellement transparente pour le rayonnement électromagnétique émis par l'émetteur (16) dans la portion d'opération (12), et
la plaque de recouvrement (10) étant configurée au moins partiellement déformable élastiquement et/ou mobile dans la portion d'opération (12),
l'au moins un récepteur (18) étant disposé et/ou configuré de telle sorte qu'il permet une détection avec résolution spatiale du rayonnement électromagnétique ; et
le bouton-poussoir possèdant en outre un dispositif de commande (20) qui est configuré pour détecter, à partir du rayonnement électromagnétique détecté avec résolution spatiale par l'au moins un récepteur (18), un écart et/ou une variation d'écart entre l'au moins un récepteur (18) et l'objet (22) et, à partir de l'écart détecté ou de la variation d'écart détectée, déterminer un état d'actionnement du bouton-poussoir,
**caractérisé en ce que** l'état d'actionnement est sélectionné entre un état d'actionnement, dans lequel la portion d'opération (12) est déformée ou décalée par une action de force depuis le côté utilisateur (10a), et au moins un état d'actionnement supplémentaire, dans lequel un objet (22) se trouve à proximité de la plaque de recouvrement (10), à proximité du bouton-poussoir ou sur la portion d'opération (12).

2. Bouton-poussoir selon la revendication 1, avec lequel le côté intérieur (10b) de la plaque de recouvrement (10) est pourvu au moins dans la portion d'opération (12) d'un revêtement (26) qui est au moins partiellement opaque pour le rayonnement dans la plage de longueurs d'onde visibles.

3. Bouton-poussoir selon l'une des revendications précédentes, avec lequel un cadre de capteur (24) se trouve sur le côté intérieur (10b) de la plaque de recouvrement (10), lequel est configuré sensiblement opaque ou absorbant pour le rayonnement électromagnétique émis par l'au moins un émetteur (16).

4. Arrangement d'opération, notamment pour un appareil ménager électronique, comprenant au moins un bouton-poussoir selon l'une des revendications précédentes.

5. Arrangement d'opération selon la revendication 4, lequel possède plusieurs boutons-poussoirs selon l'une des revendications 1 à 3, dont les émetteurs et/ou les récepteurs sont cadencés séparément par un dispositif de commande (20) commun.

6. Appareil ménager électronique comprenant au moins un arrangement d'opération selon la revendication 4 ou 5.

7. Procédé de commande d'un appareil électronique, notamment d'un appareil ménager électronique, au moyen d'au moins un bouton-poussoir, avec lequel l'au moins un bouton-poussoir comprend : une plaque de recouvrement (10) pourvue d'un côté utilisateur (10a) qui fait face à un utilisateur et d'un côté intérieur (10b) à l'opposé de l'utilisateur, la plaque de recouvrement (10) définissant une portion d'opération (12), ainsi qu'au moins un émetteur (16) destiné à émettre un rayonnement électromagnétique et au moins un récepteur (18) destiné à recevoir le rayonnement électromagnétique émis par l'émetteur (16) et réfléchi par un objet (22) sur le côté du côté utilisateur (10a) de la plaque de recouvrement (10), la plaque de recouvrement (10) étant configurée au moins partiellement transparente pour le rayonnement électromagnétique émis par l'émetteur (16) dans la portion d'opération (12) et la plaque de recouvrement (10) étant configurée au moins partiellement déformable élastiquement et/ou mobile dans la portion d'opération (12),
le rayonnement électromagnétique étant détecté par l'au moins un récepteur (18) avec résolution spatiale ; et
un écart et/ou une variation d'écart entre l'au moins un récepteur (18) et l'objet (22) étant détecté à partir du rayonnement électromagnétique détecté avec résolution spatiale par l'au moins un récepteur (18) et un état d'actionnement du bouton-poussoir étant déterminé à partir de l'écart détecté ou de la variation d'écart détectée,
**caractérisé en ce que** l'état d'actionnement est sélectionné entre un état d'actionnement, dans lequel la portion d'opération (12) est déformée ou décalée par une action de force depuis le côté utilisateur (10a), et au moins un état d'actionnement supplémentaire, dans lequel un objet (22) se trouve à proximité de la plaque de recouvrement (10), à proximité du bouton-poussoir ou sur la portion d'opération (12).

8. Procédé selon la revendication 7, avec lequel les états d'actionnement de plusieurs boutons-poussoirs sont déterminés, les émetteurs et/ou les récepteurs des plusieurs boutons-poussoirs étant cadencés séparément.
